# EUROPEAN PATENT SPECIFICATION

(11) **EP 0 883 193 B1**
(45) Date of publication and mention of the grant of the patent: **17.01.2001**
(21) Application number: 98110272.6
(22) Date of filing: 05.06.1998
(51) Int. Cl.: H01L 29/866, H01L 21/329

(54) **Method for fabricating a Zapping diode**
Herstellungsverfahren für Zap-Diode
Procédé de fabrication pour une diode zap

(30) Priority: 06.06.1997 DE 19723747
(43) Date of publication of application: 09.12.1998
(73) Proprietor: ELMOS Semiconductor AG, 44227 Dortmund (DE)
(72) Inventor: Rost, Wolfgang, 44359 Dortmund (DE)
(74) Representative: Hilleringmann, Jochen, Dipl.-Ing.

(56) References cited:
- DE-A- 3 610 328
- DE-A- 4 318 617

## Description

The present invention relates to a zapping diode, adapted to be switched with low pulse energy from a high-resistive state into a durable low-resistive state, for the adjusting or programming of integrated circuits during measurement of the circuits on wafer level or assemblied.

Diodes of the above type have been known for a long time and are used for quick and inexpensive adjustment of integrated circuits (JP 6-151897 A and JP 5-218455 A). In principle, these diodes are p-n diodes, operated in the reverse direction, which at voltages below a critical value leading to breakdown are in a high-resistive state, and upon short-term (pulsed) operation above this value become irreversibly low-resistive. This feature used to bring finished integrated circuits into a desired state (logic level, resistance value, oscillator frequency etc.).

The above described "zapping" process makes use of the energy released in the space-charge zone of the diode by the initiated current flow while the reverse voltage at the same time is above the critical breakdown level. This energy will heat the p-n junction to such an extent that the latter is destroyed and the connection between the anode and the cathode becomes low-resistive. This process is enhanced - and often made possible at all - by the fact that, due to the high temperature during the release of energy in the diode with the silicon substrate accommodating the diode, the aluminum normally used as a conductive-path and contact material will form a conductive AlSI alloy path. In case of the above combination of materials, this will occur already at the eutectic temperature of about 570°C characteristic for said combination.

Problems in zapping occur particularly if the volume-related released energy is not sufficient to reliably carry out the process or if the continued supply of aluminum via the contact surfaces is too small to form an alloy. To avoid these difficulties, the diodes are given small dimensions and provided with relatively large contact windows and wide conductive-path lead-ins. Further, provisions are suitably taken to the effect that the contact windows reach as closely as possible to the space-charge zone where the highest energy is released upon application of an inhibitory pulse of a suitable level and where the region of the highest temperature is located. The above mentioned measures fulfill the objective to reliably obtain the low-resistance state of the diode by use of the smallest possible amount of energy.

More recent technologies for integrated circuits, however, utilize not simply aluminum or an aluminum alloy for a conductive-path material, leave alone for a contact material. Because of the special demands that these technologies pose to a low-resistance, small-dimensioned and flat contacting of the elements of the circuit, use is made of metals that are not dissolved in the silicon and do not dissolve the silicon, as e.g. tungsten and titanium and their silicides. For zapping diodes, this causes additional problems because the favorable processes described above for aluminum do not take place anymore. For these metals, reactions for the formation of silicides occur substantially above 700EC, and the silicides are in turn temperature-resistant up to above 900EC, so that at least this temperature or even a temperature near the melting point must be reached to obtain the desired changes in the diode in a reproducible and reliable manner.

From DE 36 10 328 and DE-A-43 18 617 integrated diodes are known wherein the width dimension of the p-n-junctions are limited by the confronting edges of two areas of photoresistant coating applied onto the substrate during the manufacturing process.

It is an object of the invention to provide a method for making a zapping diode which is adapted to be zapped reliably and safely by low pulse energy also when using high-melting contact materials, and which can be produced at low cost.

According to the invention, the above object is solved by a method as defined in the claim.

According to the invention, the active volume of the diode wherein the energy required for zapping is released, is reduced to a well-reproducible minimum-preferably in the sub-µm region of to only a few µm, preferably between 1 and 2 µm and most preferably 1.5 µm - by self-adjusting high-dose implantations for the anode and the cathode, and that the charge carriers causing the current flow will pass completely through this volume which will experience a breakthrough first and in a controlled manner. With a voltage applied at the same time in the reverse direction, the above features are useful to reach a high power density sufficient for triggering the zapping process, while requiring relatively little absolute pulse energy.

According to the invention, a mask of polysilicon is employed which in the production of integrated circuits is normally used with highest precision and for the smallest possible dimensions, primarily for the gate electrodes of MOS transistors. A minimum gap between two polysilicon areas defines the size of that part of the diode where n- and p-areas, each being very low-resistive, contact or overlap each other and in this area form part of the p-n junction where, earlier than in other regions, already a low reverse potential will result in field strengths sufficient to cause a breakthrough in the silicon and to trigger the desired zapping process. Due to the minimum volume of this part of the p-n junction, effected by small gap in the polysilicon mask, very high energy densities are obtained already by low absolute pulse energy.

An embodiment of the invention will be described in greater detail hereunder with reference to the schematic drawings.
- Fig. 1: is a plan view of a zapping diode according to an embodiment of the invention;
- Fig. 2: is a vertical sectional view, taken along the line II-II of Fig. 1, of the active p-n junction of the zapping diode;
- Fig. 3: is a vertical sectional view, taken along the line III-III of Fig. 1, of the p-n junction and the polysilicon mask of the zapping diode.

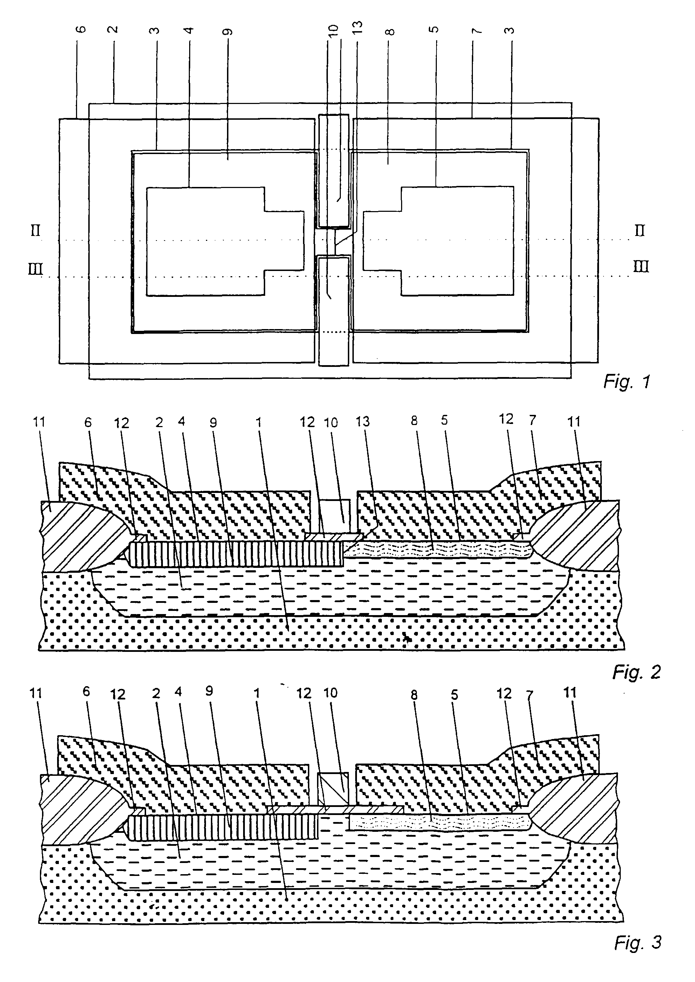

In Fig. 1, a zapping diode according to the invention is illustrated in plan view. Within an active area 3 covered by thin oxide 12 and surrounded by thicker oxide 11 in the field area, a p-conducting silicon substrate 1 has its upper surface provided with a high-resistant n-well 2 which is covered substantially by the thin oxide 12 and comprises a low-resistant p-area 9 acting as an anode and a low-resistant n-area 8 acting as a cathode. The centrally arranged polysilicon mask 10 delimits the effective volume of that part of the low-resistance n- and p-areas 8,9 which is relevant for the breakthrough of the diode, with the n- and p-areas 8,9 arranged as close to each other as possible or, as in the present example, overlapping each other. These n- and p-areas 8,9 are generated by ion implantation using a resist mask and the polysilicon mask 10 which are mutually superposed and together cover the active region.

In places where the polysilicon is arranged, the doping materials for the cathode and the anode generating the n- and p-conductance do not penetrate the sustrate 1. Contact windows for the cathode 5 and the anode 4, both of which are arranged near the active p-n junction 13, are used to connect the respective low-resistance n- and p-areas 8,9 with respectively associated cathode and anode connections 7,6 through a structured metal conductive path.

Fig. 2 shows a vertical cross-sectional view of the active p-n junction 13 of a zapping diode of the invention according to Fig. 1. In the overlapping area of the low-resistance n- and p-areas 8,9, the active p-n junction 13 relevant for the circuit element is generated without being influenced by the polysilicon mask 10.

Fig. 3 shows a vertical cross-sectional view of the p-n junction and the polysilicon mask 10 of the zapping diode according to the instant embodiment of the invention. The polysilicon mask 10 prevents an intrusion of the implanted doping materials so that the p-n junction is formed between the low-resistance p-area 9 and the n-well 2. Because of the prevailing doping conditions, critical field strengths will not occur in this region.

As best shown in Figs. 2 and 3, the zapping diode is arranged in the near-surface region of an n-conductive, high-resistance layer forming an n-well 2, which layer has been formed by methods commonly used in semiconductor technology, e.g. by implantation and/or diffusion of doping materials in a p-conducting substrate 1 of silicon. The surface of silicon substrate 1 is covered by a dielectric layer (silicon dioxide SiO2) in a suitable manner to provide a region of thin oxide 12 largely situated above n-well 2, i.e. the active layer 3 wherein the zapping diode will be arranged, and regions arranged external thereof and comprising thicker oxide 11, i.e. the so-called field region. In the process, the dielectric layer is generated by thermal oxidation wherein the different layer thicknesses in the active and field regions are obtained by local oxidation using a mask of silicon nitride to be subsequently removed; this practice is known as the LOCOS method.

On the oxide-covered silicon substrate, a polysilicon layer is then deposited which - as usually required for other parts of the integrated circuit - is also doped. Normally, the doping can be performed in a special partial step, e.g. by high-dose phosphorus implantation. In the area of the active region 3 of the zapping diode to be generated, the polysilicon layer will subsequently be structured by use of a photolithography step and an etching step such that a narrow and well-defined gap is generated therein in the region of the later p-n junction. The thus obtained polysilicon mask 10 serves for lateral self-adjustment of the active p-n junction of the zapping diode to be produced. By means of two successive doping material implantation processes, selectively performed by photoresist masks overlapping each other in the central region, in combination with the previously generated polysilicon mask 10 providing for lateral delimitation, there are generated a low-resistant n-area 8 as a cathode and a low-resistant p-area 9 as an anode overlapping the n-area 8. Due to the narrow gap in the polysilicon mask 10, the width of the overlapping region where the active p-n junction 13 is generated is very small, and due to the especially high precision in producing the polysilicon mask 10, said width is reproducible to a high extent. The small-volumed active p-n junction 13 generated in the overlapping region of the low-resistant n- and p-areas 8,9 forms the active region of the p-n junction of the zapping diode, surrounding the low-resistant p-area 9. This active region will first experience a controlled breakthrough when the reverse voltage increases.

In the present embodiment, the intended function of the zapping diode is realized by use of small absolute energy pulses and maximum volume-related energy densities. Before generating the contact windows for anode 4 and cathode 5 in the active region 3 covered by the above mentioned thin oxide 12, the whole arrangement is subjected to a full-surfaced deposition of a conformal thick dielectric layer provided to insulate mutually intersecting or contacting polysilicon or conductive path regions in other parts of the circuit from each other; since this layer is not of primary importance for the actual zapping diode, it is not explicitly illustrated in Figs. 2 and 3.

Using known photolithographic methods, the contact windows 4 and 5 are defined in size and position and are formed by wet or dry etching in the oxide arranged in n-well 2. The windows should reach to the close vicinity of the active p-n junction 13. Immediately thereafter, a metal layer is deposited which, depending on the type of the metal and respectively the barrier layer arranged on the contact window, will influence the behavior of the zapping diode. Said metal can be aluminum or an aluminum alloy or a metal adapted to form silicides when reacting with silicon. A possibly desired generation of silicides is obtained by an annealing step at a temperature up to above the reaction temperature.

A further photolithography and etching step serves for separating the anode connection 6 and the cathode connection 7.

The production process is concluded by an annealing step at substantially 450°C in a hydrogen-containing atmosphere for the general formation of contacts and for stabilizing the interface between the silicon and the oxide.

The constituent layers forming the zapping diode likewise form essential parts of other elements used in the integrated circuit. Thus, for instance, the n-well 2 is also the body region of p-channel transistors; the low-resistance n-area 8 is also the source/drain region of n-channel transistors; the low-resistance p-area 9 is also the source/drain region of p-channel transistors; and the polysilicon layer from which the polysilicon mask 10 has been etched is generally the gate electrode material for MOS transistors. As a result, the zapping diode of the invention can be produced at low cost.

## Claims

1. Method for making a zapping diode comprising an active p-n junction (13) between a low-resistant n-area (8) as a cathode and a low-resistant p-area (9) as an anode which both are arranged within a high-resistance n-well (2) formed in a p-conducting silicon substrate (1), wherein the method comprises:
- forming over the p-conducting silicon substrate (1) within the area the n-well (2) two mutually opposite polysilicon masking regions (10) having confronting edges spaced from each other and
- forming the low resistant n- and p-areas (8,9) in the n-well (2) by a self-adjusting implantation such that the width dimension of the active p-n junction (13) transversely to the current direction is on both sides delimited in a reproducible manner by said confronting edges of the polysilicon masking regions (10) with the n- and p-areas (8,9) contacting or overlapping each other in the area between the confronting edges of the two polysilicon masking regions (10) and spaced from each other within the area below the polysilicon masking regions (10).

## Patentansprüche

1. Verfahren zum Herstellen einer Zappingdiode mit einem aktiven pn-Übergang (13) zwischen einem niederohmigen n-Gebiet (8) als Kathode und einem niederohmigen p-Gebiet (9) als Anode, die beide innerhalb einer in einem p-leitenden Siliciumsubstrat (1) eingebrachten hochohmigen n-Wanne (2) angeordnet sind, mit den folgenden Schritten:
- Bilden zweier einander gegenüberliegender Polysilicium-Maskierbereiche (10) mit voneinander beabstandeten gegenüberliegenden Rändern, und zwar über dem p-leitenden Siliciumsubstrat (1) innerhalb des Gebiets der n-Wanne (2),
- Bilden der niederohmigen n- und p-Gebiete (8,9) in der n-Wanne (2) durch eine selbsteinstellende Implantation derart, dass die Breitenbemessung des aktiven pn-Übergangs (13) quer zu der Stromrichtung auf beiden Seiten auf reproduzierbare Weise durch die einander gegenüberliegenden Ränder der Polysilicium-Maskierbereiche (10) begrenzt ist, wobei die n- und p-Gebiete einander in dem Bereich zwischen den einander gegenüberliegenden Rändern der beiden Polysilicium-Maskierbereiche (10) kontaktieren oder überlappen und innerhalb des unterhalb der Polysilicium-Maskierbereiche (10) gelegenen Gebiets voneinander beanstandet sind.

## Revendications

1. Procédé pour fabriquer une diode de modification comprenant une jonction p-n active (13) entre une zone de type n (8) de faible valeur résistive, en tant que cathode, et une zone de type p (9) de faible valeur résistive, en tant qu'anode, ces deux zones étant disposées à l'intérieur d'un puits de type n (2) de forte valeur résistive, formé dans un substrat en silicium (1) conducteur de type p, le procédé comprenant :
- la formation, sur le substrat en silicium (1) conducteur de type p à l'intérieur de la zone du puits (2) de type n, de deux régions de masquage en polysilicium (10) opposées l'une à l'autre et possédant des bords en vis-à-vis qui sont séparés l'un de l'autre, et
- la formation des zones de type n et de type p (8,9) de faible valeur résistive dans le puits de type n (2) au moyen d'une implantation avec auto-alignement de telle sorte que la dimension en largeur de la jonction p-n active (13) transversalement par rapport à la direction du courant est limitée des deux côtés, d'une manière reproductible, par lesdits bords en vis-à-vis des régions de masquage en polysilicium (10), les zones de type p et n (8,9) étant en contact ou en chevauchement réciproque dans la zone située entre les bords en vis-à-vis des deux régions de masquage en polysilicium (10) et étant espacées l'une de l'autre à l'intérieur de la zone située au-dessous des régions de masquage en polysilicium (10).
